# EUROPEAN PATENT APPLICATION

(11) **EP 3 644 693 A1**
(43) Date of publication of application: **29.04.2020**
(21) Application number: 18202060.2
(22) Date of filing: 23.10.2018
(51) Int. Cl.: H05K 1/18, H05K 3/46

(54) **SURFACE MOUNTED DEVICE IN CAVITY**

(71) Applicant: AT & S Austria Technologie & Systemtechnik Aktiengesellschaft, 8700 Leoben-Hinterberg (AT)
(72) Inventor: Schober, Mario, 8793 Trofaiach (AT); Leitgeb, Markus, 8793 Trofaiach (AT)
(74) Representative: Dilg, Haeusler, Schindelmann Patentanwaltsgesellschaft mbH

(57) **Abstract**

The present invention relates to a component carrier comprising a stack with at least one electrically insulating layer structure and/or at least one electrically conductive layer structure and having a cavity, a first active component mounted in the cavity and on a first main surface of the stack and a second active component mounted on a second main surface of the stack and being connected to the first active component via the stack.

## Description

### Field of invention

The invention relates to a component carrier comprising a stack with at least two components. Furthermore, the present invention relates to a method of manufacturing a component carrier. Furthermore, the present invention relates to an electric device comprising the component carrier.

### Art Background

The increase of the intrinsic switching speeds or the higher transfer rates in the field of integrated circuits make it necessary to arrange a processor and a memory as close as possible to each other, because this will make high transfer rates possible and risk of data loss is minimized. In addition, a balanced heat management in the package is necessary for the greatest possible computing power from the active components. In addition, the smallest possible pitch between a package and a mainboard required may be limited by the height of the package soldering depot which leads to a limitation in the smallest possible thickness.

A component carrier, such as a printed circuit board (PCB) or a substrate, mechanically supports and electrically connects active and passive electronic components. Electronic components are mounted on the component carrier and are interconnected to form a working circuit or electronic assembly.

Component carriers can be single sided or double sided component carriers or can have a multi-layer design. Advantageously, multi-layer component carriers allow a high component density which becomes nowadays, in times of an ongoing miniaturization of electronic components, more and more important. Conventional component carriers known from the state of the art comprise a laminated stack with a plurality of electrically insulating layer structures and a plurality of electrically conductive layer structures. The electrically conductive layers are usually connected to each other by so called microvias or plated-through holes. A conductive copper layer on the surface of the laminated stack forms an exposed structured copper surface. The exposed structured copper surface of the laminated stack is usually covered with a surface finish which completely covers the exposed structured copper surface.

There may be a need for flat component carriers comprising an effective signal processing and a proper heat management.

### Summary of the Invention

This need may be met by the subject matter according to the independent claims. Advantageous embodiments of the present invention are described by the dependent claims.

According to a first aspect of the invention a component carrier is presented. The component carrier comprises a stack comprising at least one electrically insulating layer structure and/or at least one electrically conductive layer structure and having a cavity. Furthermore, the component carrier comprises a first (active or passive) component mounted in the cavity and on a first main surface of the stack. Furthermore, the component carrier comprises a second (active or passive) component mounted on a second main surface of the stack and being connected to the first component via the stack.

According to a further aspect of the present invention, a method of manufacturing a component carrier is presented. According to the method, a stack is provided comprising at least one electrically insulating layer structure and/or at least one electrically conductive layer structure, with a cavity. A first (active or passive) component is mounted in the cavity and on a first main surface of the stack. A second (active or passive) component is mounted on a second main surface of the stack to thereby connect the second component with the first component via the stack.

According to a further aspect of the present invention an electric device is presented comprising a support structure, in particular a printed circuit board and an above described component carrier mounted on the support structure. According to a further exemplary embodiment of the method, after the step of mounting the first component and the second component to the stack, the component carrier is mounted to the support structure, in particular a printed circuit board.

In the context of the present application, the term "component carrier" may particularly denote any support structure which is capable of accommodating active and/or passive components thereon and/or therein for providing mechanical support and/or electrical connectivity. In other words, a component carrier may be configured as a mechanical and/or electronic carrier for active and passive components. In particular, a component carrier may be one of a printed circuit board, an organic interposer, and an IC (integrated circuit) substrate. A component carrier may also be a hybrid board combining different ones of the above mentioned types of component carriers.

The component carrier comprises the stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure, if desired supported by thermal energy. The mentioned stack may provide a plate-shaped component carrier capable of providing a large mounting surface for further components and being nevertheless very thin and compact. The term "layer structure" may particularly denote a continuous layer, a patterned layer or a plurality of nonconsecutive islands within a common plane. In the context of the present invention, the term "layer structure" may be a single layer or multilayer assembly.

The stack and/or the supporting structure, such as the PCB, may comprise a coreless type structure. In a coreless type structure the several layers are laminated above each other such that in the final product no central core structures/bodies exist. For manufacturing the coreless stack or supporting structure a carrier, specifically a sacrificial carrier or temporary carrier, may be used. The final product is free of a core or a carrier. However, even if further cores exist in the final product but which cores were not used for laminating the several layers above each other, this type is also called coreless structure.

Active components may be defined as a component which rely on a source of energy (e.g. from a DC circuit) and usually may inject power into a circuit. Active components may include amplifying components such as transistors, triode vacuum tubes (valves), and tunnel diodes. Active components may be for example semiconductors, diodes, transistors, integrated circuits (ICs), optoelectronic devices, display technologies or kind of power sources.

Components incapable of controlling current by means of another electrical signal are called passive components. Resistors, capacitors, inductors, and transformers are considered as passive components. Passive components may e.g. not introduce net energy into the circuit. Passive components may not rely on a source of power, except for what is available from a circuit they are connected to. As a consequence passive components may not amplify (increase a power of a signal), although they may increase a voltage or current (such as is done by a transformer or resonant circuit). Passive components include two-terminal components such as resistors, capacitors, inductors, and transformers.

The stack comprises a first main surface and the second main surface which differs to the first main surface. In particular, the first main surface and the second main surface form opposing surfaces of the stack. For example, the first main surface comprising the cavity is adapted for being mounted to a further structure, such as a support structure, in particular a printed circuit board. The second surface, which may be a surface opposed to the first main surface, may face the environment in order to dissipate heat, for example. The first main surface comprises the surface surrounding the cavity as well as the surface of the cavity itself.

The first main surface and/or the second main surface may be formed by a structured electrically conductive layer structure of the stack. Accordingly, electrical contact, such as contact pads or solder balls for example, may be formed on the first main surface and/or second main surface.

The cavity is formed in the stack along the first main surface. The surface of the cavity is part of the first main surface and forms a recess with respect to the surface of the first main surface surrounding the cavity. The cavity is formed in such a way, that the first component can be placed inside the cavity. The first component may protrude outside of the cavity with respect to the surface surrounding the cavity and the connecting elements mounted onto the surface of a first main surface. However, according to an exemplary embodiment, the cavity is formed in such a way, that the first component does not protrude from the surface surrounding the cavity. In other words, the surface surrounding the cavity is formed within a plane, wherein the first component does not protrude from the cavity through the plane.

The cavity may be formed by mechanical techniques, such as drilling, for example mechanical drilling or laser drilling. Additionally, cavities can be formed by using DFR or Photoimageable dielectrics, which are removed in a developing process. Furthermore, the cavity may be formed by etching the stack. Furthermore, during build up the stack layerwise, release layers, such as Teflon or wax may be used which can be removed after forming the stack. Embedding the release layer may be accomplished by laminating the release layer in an interior of the layer structures of stack. The material of the release layer (for instance a waxy component) may be selected so as to provide a poor adhesion with respect to surrounding material of the stack. A piece of material of the stack above the release layer is removed to thereby form a cavity. This can be accomplished by forming a circumferential cut along a cutting line, for instance with a laser beam. In view of the poor adhesion between the material of the release layer and surrounding material of the stack, piece may subsequently simply be taken out from the stack. As a result, the cavity in stack is obtained. The release layer may be removed thereafter at least partially. The component is then mounted and thereby embedded in the cavity. Before inserting, it is possible that an adhesive material is placed in the cavity to improve adhesion between the stack and the component. When the height of the respective component is larger than the height of the cavity, a protruding portion is formed. When the height of the respective component is smaller than the height of the cavity, a recess is formed.

The first component which is arranged in the cavity on the first main surface and the second component which is arranged on the second main surface are electrically connected via the stack. For example, if the first main surface and the second main surface form opposed sides of the stack, through contacts, such as vias, may be formed with in the stack for providing the connection of the two components. Hence, the component carrier may form an interposer providing the electrical contact between the first component carrier and the second component carrier.

In conventional approaches, the first component is formed on a further structure, such as a printed circuit board (PCB). After mounting the component carrier with a second component to the PCB, the second component is connected to the first component. Hence, in order to mount the active component to the PCB, PCB itself has to be adapted and prepared.

However, according to the approach of the present invention, components are mounted to one common component carrier, such that the base structure, such as the PCB, has not to be amended and specifically prepared. No cut out or cavity is necessary to be formed in the PCB. All preparations, such as the cavity, are formed within the component carrier. Therefore, e.g. standardized PCBs can be used. Furthermore, due to the arrangement of the first component within the cavity, the height and the pitch, respectively, of an overall package can be reduced. Therefore, for example the necessary stand-off function of solder balls for the mounting of substrates of the PCB can be reduced. This leads to an increase of I/Os (input/output) by having the same available area or to a reduction of the footprints having the same available area. Furthermore, because all component can be mounted to the component carrier, the common chip-last technology can be performed, because the component carrier as well as the components mounted thereon can be tested comprehensively before being mounted to a base structure.

According to a further exemplary embodiment, the second component is mounted in a further cavity of the stack. Hence, if the second component is mounted in a further cavity along the second main surface, the overall height can be further reduced.

According to a further exemplary embodiment, the first component and the second component collaborate functionally. Hence, in addition to an electrical connection between the first component and the second component, the term "collaborate functionally" means that the first component and the second component are functionally dependent on each other. For example, the second component may be a processor and the first component a memory which is accessible by the processor. Hence, the first component and the second component forms a functional unit in which both components collaborate functionally.

According to an exemplary embodiment of the method, a via is formed in the stack, wherein the via is configured for providing a functional collaboration between the first component and the second component.

According to a further exemplary embodiment, the cavity is formed such that the first component do not protrude over the cavity and in particular connecting elements mounted onto the surface of a first main surface. As described above, the surface surrounding the cavity is formed within a plane, wherein the first component does not protrude from the cavity through the plane. Hence, if the component carrier is mounted with its first main surface to a further base structure, the first component does not form a spacer between both structures, i.e. the component carrier and the base structure. Hence, between the base structure and the component carrier, for example only the necessary solder balls are arranged between the first main surface and the respective opposing surface of the base structure.

According to a further exemplary embodiment, at least one of the first component and the second component is an active component.

According to a further exemplary embodiment, wherein the at least one of the first component and second component is a semiconductor chip.

According to a further exemplary embodiment, the first active component is a memory and the second active component is a processor. Hence, by the present invention the processor and the memory are formed in one component carrier instead of separate packages onto a base structure, e.g. a mainboard. By mounting the memory and the processor separately to the main board, longer transmitting paths for the signals are necessary because the signals had to be transmitted via the main port. Hence, by providing the memory in the cavity of the stack and additionally by providing the processor on/in the same stack, the memory and the processor and hence also the component carrier and the mainboard can be placed closer to each other. Additionally, the solder depot which is necessary for the connection can be formed smaller such that a smaller pitch (z-axis thickness) between the component carrier (package) and the mainboard forming the base structure can be provided.

According to a further exemplary embodiment, the component carrier further comprises at least one further active and/or passive component, wherein the further active and/or passive component is surface-mounted on and/or embedded in the stack.

According to a further exemplary embodiment, the further active and/or passive component is configured for collaborating functionally with at least the one of the first active component and the second active component.

According to a further exemplary embodiment, the at least one electrically conductive layer structure comprises at least one of the group consisting of copper, aluminum, nickel, silver, gold, palladium, and tungsten, any of the mentioned materials being optionally coated with supra-conductive material such as graphene.

According to a further exemplary embodiment, the first component comprises a first component main surface, wherein the first component is mounted to the stack such that the first component main surface is parallel with respect to the first main surface of the stack. Additionally or alternatively, the second component comprises a second component main surface, wherein the second component is mounted to the stack such that the second component main surface is parallel with respect to the second main surface of the stack.

The first and second components may comprises, respectively, a two opposing component main surfaces. For example, the one component main surface is adapted for being mounted to a further structure, such as the stack or a support structure, in particular a printed circuit board. The other opposing component main surface, may face the environment in order to dissipate heat or may be connected to another stack or supporting structure, for example. The components may comprise at the respective component main surfaces electrical connections for receiving or transmitting signals or power. The respective component main surfaces may be formed by a structured electrically conductive layer structure of the stack. Accordingly, electrical contact, such as contact pads or solder balls for example, may be formed on the respective component main surfaces.

The main surfaces of the stack as well as the respective component main surfaces extend within respective parallel xy-planes. The z-direction is the direction of the normal of the respective xy-planes. Specifically, the z-direction defines a vertical direction of the stack and the component. According to exemplary embodiment, the respective component main surface may be parallel with respect to the respective main surface of the stack to which the respective component is mounted.

According to a further exemplary embodiment, the first component comprises a first component main surface, wherein the second component comprises a second component main surface. The first component and the second component are mounted to the stack such that the first component main surface is parallel with respect to the second component main surface.

According to a further exemplary embodiment of the electrical device, the support structure comprises a support main surface, wherein the component carrier is mounted to the support structure such that the first main surface of the component carrier is parallel with the support main surface. The first main surface of the component carrier of the stack may be indicative to the first main surface of the stack and parallel to the support main surface. The support main surface may comprises electrical connections for signal and power transmission in order to provide a connection with respective electrical contacts of the first main surface of the stack.

According to a further exemplary embodiment, the at least one electrically insulating layer structure comprises at least one of the group consisting of resin, in particular reinforced or non-reinforced resin, for instance epoxy resin or Bismaleimide-Triazine resin, FR-4, FR-5, cyanate ester, polyphenylene derivate, glass, prepreg material, polyimide, polyamide, liquid crystal polymer, epoxy-based Build-Up Film, polytetrafluoroethylene, a ceramic, and a metal oxide.

According to a further exemplary embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an exemplary embodiment, the component carrier is configured as one of the group consisting of a printed circuit board, and a substrate (in particular an IC substrate). In the context of the present application, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing spheres (such as glass spheres).

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

### Brief Description of the Drawing

Figure 1 illustrates a component carrier mounted to a support structure according to an exemplary embodiment of the present invention.
Figures 2 to 10 illustrate a manufacturing of the component carrier according to an exemplary embodiment of the present invention.
Figure 11 illustrates a component carrier mounted to a support structure having a further active and/or passive components according to an exemplary embodiment of the present invention.

### Detailed Description

The illustration in the drawing is schematic. It is noted that in different figures, similar or identical elements or features are provided with the same reference signs or with reference signs, which are different from the corresponding reference signs only within the first digit. In order to avoid unnecessary repetitions elements or features which have already been elucidated with respect to a previously described embodiment are not elucidated again at a later position of the description.

Further, spatially relative terms, such as "front" and "back", "above" and "below", "left" and "right", et cetera are used to describe an element's relationship to another element(s) as illustrated in the figures. Thus, the spatially relative terms may apply to orientations in use which differ from the orientation depicted in the figures. Obviously all such spatially relative terms refer to the orientation shown in the figures only for ease of description and are not necessarily limiting as an apparatus according to an embodiment of the invention can assume orientations different than those illustrated in the figures when in use.

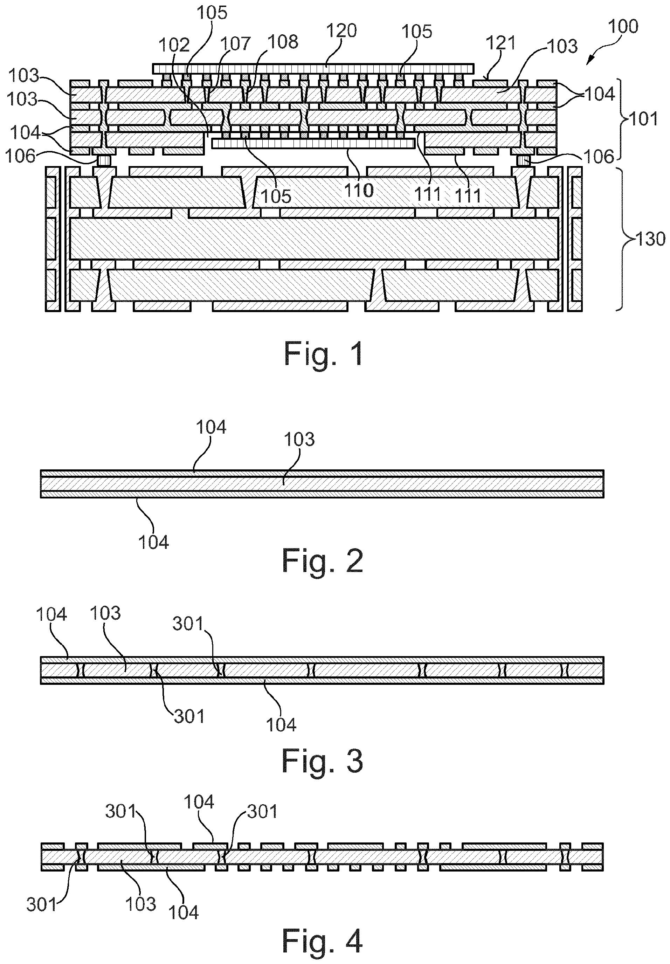

**Figure 1** shows an electric device comprising a support structure 130, in particular a printed circuit board and a component carrier 100 mounted on the support structure 130. The component carrier 100 comprises a stack 101 with at least one electrically insulating layer structure 103 and/or at least one electrically conductive layer structure 104 and having a cavity 102. A first component 110 is mounted in the cavity 102 and on a first main surface 111 of the stack 101. A second component 120 is mounted on a second main surface 121 of the stack 101 and being connected to the first component 110 via the stack 101. In the shown exemplary embodiment, the first component 110 and the second component 120 may be active components.

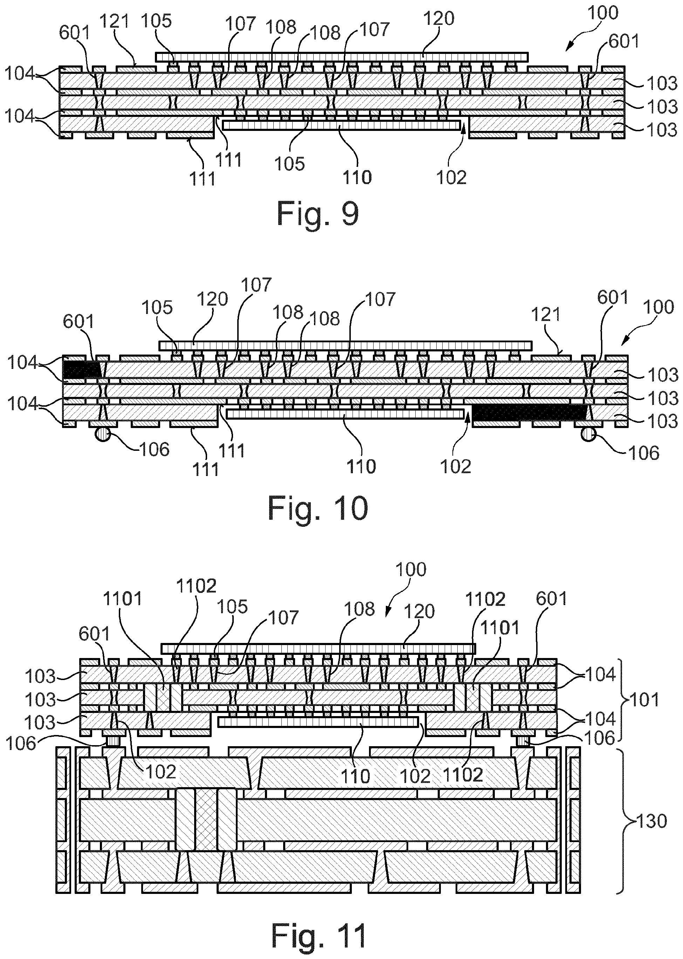

The component carrier 100 is a support structure which is capable of accommodating active components 110, 120 thereon and/or therein for providing mechanical support and/or electrical connectivity. The component carrier 100 is configured as a mechanical and/or electronic carrier for active and passive components 110, 120, 1101 (see Figure 11). In particular, a component carrier 100 may be one of a printed circuit board, an organic interposer, and an IC (integrated circuit) substrate. A component carrier 100 may also be a hybrid board combining different ones of the above mentioned types of component carriers.

The component carrier 100 comprises the stack of at least one electrically insulating layer structure 103 and at least one electrically conductive layer structure 104. The component carrier 100 is in particular a laminate of the mentioned electrically insulating layer structure(s) 103 and electrically conductive layer structure(s) 104, in particular formed by applying mechanical pressure, if desired supported by thermal energy. The mentioned stack 101 may provide a plate-shaped component carrier 100 capable of providing a large mounting surface 111, 112 for the active components 110, 120 and being nevertheless very thin and compact.

The stack 101 comprises a first main surface 111 and the second main surface 121 which differs to the first main surface 111. In particular, the first main surface 111 and the second main surface 121 form opposing surfaces of the stack 101. For example, the first main surface 111 comprising the cavity 102 is adapted for being mounted to the support structure 130, in particular a printed circuit board. The second surface 121, which may be a surface opposed to the first main surface 111, may face the environment in order to dissipate heat, for example.

The first main surface 111 and/or the second main surface 121 may be formed by a structured electrically conductive layer structure 104 of the stack 101. Accordingly, electrical contact, such as contact pads 105 or solder balls 106 for example, may be formed on the first main surface 111 and/or second main surface 121.

The cavity 102 is formed in the stack 101 along the first main surface 111. The surface of the cavity 102 is part of the first main surface 111 and forms a recess with respect to the surface of the first main surface 111 surrounding the cavity 102. The cavity 102 is formed in such a way, that the first active component 110 can be placed inside the cavity 102. The cavity 102 is formed in such a way, that the first active component 110 does not protrude from the surface surrounding the cavity 102 and the connecting elements (e.g. the solder balls 106). The surface surrounding the cavity 102 is formed within a plane, wherein the first active component 110 does not protrude from the cavity 102 through the plane. Hence, if the component carrier 100 is mounted with its first main surface 111 to the base structure 130, the first active component 110 does not form a spacer between both structures 100, 130. Hence, between the base structure 130 and the component carrier 110, for example only the necessary solder balls 106 are arranged between the first main surface 111 and the respective opposing surface of the base structure 130.

The first active component 110 which is arranged in the cavity 102 on the first main surface 111 and the second active component 120 which is arranged on the second main surface 121 are electrically connected via the stack 102. For example, through contacts, such as vias 107 or other contact holes 108 are formed within the stack 101 for providing the connection of the two active components 110, 120 or a specific electrically conductive layer structure 104 inside the stack 101. Hence, the component carrier 100 may form an interposer providing the electrical contact between the first component carrier 110 and the second component carrier 120.

As can be taken from Figure 1, the active components 110, 120 are mounted to one common component carrier 100, such that the base structure 130, such as the PCB, has not to be amended and specifically prepared. No cut out or cavity is formed in the base structure 130. All preparations, such as the cavity 102, are formed within the component carrier 100.

The first active component 110 and the second active component 120 collaborate functionally. Hence, in addition to an electrical connection 107 between the first active component 110 and the second active component 120, the first active component 110 and the second active component 120 are functionally dependent on each other. For example, the second active component 120 may be a processor and the first active component 110 a memory which is accessible by the processor. Hence, the first active component 110 and the second active component 120 forms a functional unit in which both active components 110, 120 collaborate functionally.

Specifically, first active component 110 is a memory and the second active component 120 is a processor. Hence, by the present invention the processor and the memory are formed in one component carrier 100 instead of separate packages onto a base structure 130, e.g. a mainboard. By mounting the memory and the processor separately to the main board, longer transmitting paths for the signals are necessary because the signals had to be transmitted via the main port.

Furthermore, the second active component 120 is arranged on the second main surface 121 which faces the environment of the component carrier 100. Hence, the heat dissipation of the second active component 120, such as a processor, is provided.

**Figure 2** to **Figure 10** illustrate a manufacturing process of the component carrier 100 according to an exemplary embodiment of the present invention.

**Figure 2** shows the formation of a core material comprising a central electrically insulating layer structure 103 being covered by respective layers of electrically conductive layer structures 104.

In a next step according to **Figure 3****,** through contacts 301 between the electrically conductive layer structures 104 are formed.

In a next step according to **Figure 4**, the electrically conductive layer structures 104 are structured in order to provide a desired electrical path and connection scheme, respectively, through the core material.

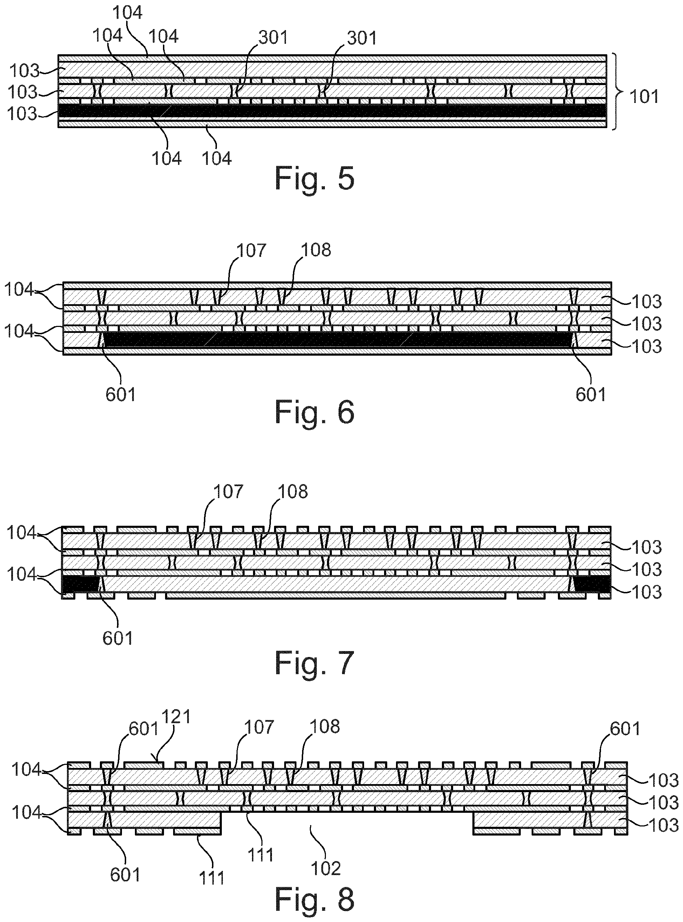

**Figure 5** illustrates, that also additional further electrically insulating layer structures 103 and electrically conductive layer structures 104 can be added. In a next step according to **Figure 6**, through contacts such as vias 107, contact holes 108 and further vias 601, which connect the electrically conductive layer structures 104 facing the environment. The added electrically conductive layer structures 104 are connected to the electrically conductive layer structures 104 of the core conductive layer structures 104.

**Figure 7** the previously added electrically conductive layer structures 104 are structured in order to provide a desired electrical path and connection scheme, respectively.

In a next step according to **Figure 8**, the cavity 102 for the respective active component 110 is formed within the first main surface 111. The cavity 102 may be formed through several layers of the stack 101, such as through the outer electrically conductive layer structure 104 and the first electrically insulating layer structure 103 as shown in Figure 8.

In a next step according to **Figure 9**, the first active component 110 is mounted within the cavity 102. The first active component 110 is connected by respective contacts 105, such as solder pads, to the respective structured electrically conductive layer structure 104. Accordingly, the second active component 120 is mounted to the second main surface 121. The second active component 120 is connected by respective contacts 105, such as solder pads, to the respective structured electrically conductive layer structure 104.

Vias 107 form an electrically conductive path between the first active component 110 and the second active component 120. Additionally, further contact holes 108 are provided, which provides an electrical contact between the respective active components 110, 120 to respective electrically conductive layer structures 104.

In a next step according to **Figure 10**, electronic connection elements, such as the solder balls 106, may be added to the respective contacts and electrically conductive layer structures 104 of the component carrier 100. Hence, after the step of mounting the first active component 110 and the second active component 120 to the stack 101, the component carrier 100 is mounted to the support structure 130, in particular a printed circuit board (e.g. a motherboard). The component carrier 100 forms a structurally independent unit, so that the active components 110, 120 mounted to the component carrier 100 and which collaborate functionally with each other can be tested separately without being mounted to a further support structures 130. Hence, after completely testing the component carrier 100 further mounting is provided. This supports the common chip-last technology, for example.

**Figure 11** shows a component carrier 100 mounted on a support structures 130. The arrangement shown in Figure 11 is similar to the one in Figure 1. Additionally, the component carrier 100 comprises a further active and/or passive component 1101. The further active and/or passive component 1101 is configured for collaborating functionally with at least the one of the first active component 110 and the second active component 120. The further active and/or passive component 1101 is connected for example by a further via 1102 to the first or second active component 110, 120 or to a desired electrically insulating layer structure 104.

It should be noted that the term "comprising" does not exclude other elements or steps and the "a" or "an" does not exclude a plurality. Also elements described in association with different embodiments may be combined. It should also be noted that reference signs in the claims shall not be construed as limiting the scope of the claims. Implementation of the invention is not limited to the preferred embodiments shown in the figures and described above. Instead, a multiplicity of variants are possible which use the solutions shown and the principle according to the invention even in the case of fundamentally different embodiments.

### Reference Numerals:

100 component carrier
101 stack
102 cavity
103 insulating layer structure
104 conductive layer structure
105 contact
106 solder ball
107 via
108 contact hole
110 first active component
111 first main surface
120 second active component
121 second main surface
130 support structure
301 through contact
601 further via
1101 further active or passive component
1102 further via

## Claims

1. Component carrier (100), comprising:
a stack (101) comprising at least one electrically insulating layer structure (103) and/or at least one electrically conductive layer structure (104) and having a cavity (102);
a first component (110) mounted in the cavity (102) and on a first main surface (111) of the stack (101); and
a second component (120) mounted on a second main surface (121) of the stack (101) and being connected to the first active component (110) via the stack (101).

2. Component carrier (100) according to claim 1,
wherein the second component (120) is mounted in a further cavity (102) of the stack (101)

3. Component carrier (100) according to claim 1 or 2,
wherein the first component (110) and the second component (120) collaborate functionally.

4. Component carrier (100) according to one of the claims 1 to 3,
wherein the cavity (102) is formed such that the first active component (110) do not protrude over the cavity (102) and connecting elements mounted onto the surface of a first main surface (111).

5. Component carrier (100) according to one of the claims 1 to 4,
wherein at least one of the first component (110) and the second component (120) is an active component.

6. Component carrier (100) according to claim 5,
wherein the at least one of the first active component (110) and the second active component (120) is a semiconductor chip.

7. Component carrier (100) according to claim 5 or 6,
wherein the first active component (110) is a memory and the second active component (120) is a processor.

8. Component carrier (100) according to one of the claims 1 to 7,
wherein at least one further active and/or passive component (1101) is surface-mounted on and/or embedded in the stack (101)
wherein in particular the further active and/or passive component (1101) is configured for collaborating functionally with at least the one of the first component (110) and the second component (120).

9. Component carrier (100) according to one of the claims 1 to 8,
wherein the first component (110) comprises a first component main surface, wherein the first component (110) is mounted to the stack (101) such that the first component main surface is parallel with respect to the first main surface (111) of the stack, and/or
wherein the second component (120) comprises a second component main surface,
wherein the second component (120) is mounted to the stack (101) such that the second component main surface is parallel with respect to the second main surface (121) of the stack (101).

10. Component carrier (100) according to one of the claims 1 to 9,
wherein the first component (110) comprises a first component main surface, wherein the second component (120) comprises a second component main surface,
wherein the first component (110) and the second component (120) are mounted to the stack (101) such that the first component main surface is parallel with respect to the second component main surface.

11. Method of manufacturing a component carrier (100), wherein the method comprises:
providing a stack (101), comprising at least one electrically insulating layer structure (103) and/or at least one electrically conductive layer structure (104), with a cavity (102);
mounting a first component (110) in the cavity (102) and on a first main surface (111) of the stack (101);
mounting a second component (120) on a second main surface (121) of the stack (101) to thereby connect the second component (120) with the first component (110) via the stack (101).

12. Method according to claim 11, further providing
forming a via (107) in the stack (101),
wherein the via (107) is configured for providing a functional collaboration between the first component (110) and the second component (120).

13. Method according to claim 11 or 12, further providing after the step of mounting the first component (110) and the second component (120) to the stack (101):
mounting the component carrier (100) to a support structure (130), in particular a printed circuit board.

14. Electric device, wherein the electric device comprises:
a support structure (130), in particular a printed circuit board;
a component carrier (100) according to claim 1 mounted on the support structure (130).

15. Electric device according claim 14,
wherein the support structure (130) comprises a support main surface, wherein the component carrier (100) is mounted to the support structure (130) such that the first main surface of the component carrier (100) is parallel with the support main surface.
